# EUROPÄISCHE PATENTANMELDUNG

(11) **EP 2 015 620 A2**
(43) Veröffentlichungstag der Anmeldung: **14.01.2009**
(21) Anmeldenummer: 08010671.9
(22) Anmeldetag: 12.06.2008
(51) Int. Cl.: H05K 3/02, H05K 3/20

(54) **Heißprägen von Strukturen**

(30) Priorität: 14.06.2007 DE 102007027999
(71) Anmelder: Leonhard Kurz Stiftung & Co. KG, 90763 Fürth (DE)
(72) Erfinder: Schindler, Ulrich, Dr., 90762 Fürth/Bayern (DE)
(74) Vertreter: LOUIS, PÖHLAU, LOHRENTZ

(57) **Zusammenfassung**

Es wird ein Verfahren zur Erzeugung von Strukturen auf Substraten beschrieben. Mindestens eine Transferschicht (22) wird von einer Prägefolie (2), insbesondere einer Heißprägefolie, vollständig oder bereichsweise auf die Oberfläche des Substrats (1) übertragen, wobei die Transferschicht (22) Bereiche aufweist, die von einem Bindemittel gebildet sind. In der auf das Substrat (1) übertragenen Transferschicht werden offene Poren erzeugt, indem das Bindemittel ausgetrieben wird. In die offenen Poren kann sodann ein Füllstoff eingebracht werden. Weiter wird eine Prägefolie zur Erzeugung von Strukturen auf einem Substrat beschrieben.

## Beschreibung

Die Erfindung betrifft ein Verfahren zur Erzeugung von Strukturen, wie Leiterbahnen, sowie eine Prägefolie zur Durchführung des Verfahrens.

Zur Ausbildung von Leiterbahnen ist bekannt, diese durch Flachbettsiebdruck auf ein Substrat, beispielsweise einen für die Herstellung eines photovoltaischen Moduls vorgesehenen Silizium-Wafer aufzubringen und sodann durch Sintern dauerhaft mit der Substratoberfläche zu verbinden.

Flachbettsiebdruck ist ein zeitaufwendiges Verfahren und für eine kontinuierliche Fertigung und eine kostengünstige Massenproduktion schlecht geeignet. Insbesondere können beim Flachbettsiebdruck die Kanten des Druckbilds während des Druckens und besonders beim Druck abrasiver Medien ausbrechen. Dies kann Ungleichmäßigkeiten im Druckbild der Leiterbahnen der Elektroden und damit ungleichmäßige elektrische Eigenschaften der Elektroden zur Folge haben.

In der DE 689 26 361 T2 sind ein Verfahren und eine Vorrichtung zum Druck- und Wärmekleben eines dünnen Films auf eine Basisplatte beschrieben. Bei der Basisplatte kann es sich beispielsweise um ein elektronisches Schaltkreis-Substrat aus Silizium, Gallium-Arsenid oder ähnlichem handeln. Zur Vermeidung von Hohlräumen zwischen dem Film und der Basisplatte ist das Anlegen von Vakuum vorgesehen.

Aufgabe der vorliegenden Erfindung ist es, ein verbessertes Verfahren zum Aufbringen von Strukturen auf das Substrat anzugeben.

Erfindungsgemäß wird diese Aufgabe mit einem Verfahren zur Erzeugung von Strukturen auf einem Substrat gelöst, wobei vorgesehen ist, dass mindestens eine Transferschicht von einer Prägefolie, insbesondere einer Heißprägefolie, vollständig oder bereichsweise auf die Oberfläche des Substrats übertragen wird, wobei die Transferschicht Bereiche aufweist, in denen die Transferschicht Partikel und ein Bindemittel enthält, und dass sodann in der auf das Substrat übertragenen Transferschicht offene Poren erzeugt werden, indem das Bindemittel ausgetrieben wird und hierdurch poröse Strukturen auf dem Substrat erzeugt werden. Weiter wird die Aufgabe mit einer Prägefolie, insbesondere Heißprägefolie, zur Erzeugung von Strukturen auf Substraten gelöst, wobei vorgesehen ist, dass die Prägefolie mindestens eine Transferschicht mit Bereichen aufweist, in denen die Transferschicht Partikel und ein Bindemittel enthält, wobei durch Austreiben des Bindemittels in der Transferschicht offene Poren zur Erzeugung von porösen insbesondere leiterbahnförmigen Strukturen erzeugbar sind.

Das erfindungsgemäße Verfahren sieht also vor, die Ausbildung von Strukturen, wie beispielsweise Leiterbahnen im Wesentlichen in einen vorgelagerten Fertigungsschritt zu verlagern, nämlich in die Fertigung von Prägefolien, insbesondere Heißprägefolien. Die Herstellung von Heißprägefolien, erfüllt höchste Ansprüche an die Passergenauigkeit der Strukturen, wobei es sich bei den Strukturen beispielsweise um Leiterbahnen im herkömmlichen Sinne als auch um Elektroden oder sonstige elektrisch leitenden Bereiche oder Funktionsschichten eines Bauelements oder dergleichen handeln kann. Die erfinderische Lösung eröffnet nun die Möglichkeit, auf besonders einfache Weise auch poröse Strukturen herzustellen, die beispielsweise zur Ausbildung spezieller Elektroden oder Funktionsschichten benötigt werden.

Heißprägefolien werden vorzugsweise in einem Rolle-zu-Rolle-Verfahren hergestellt. Dabei können wichtige funktionelle Parameter der Transferschicht, wie Materialzusammensetzung, Dicke, Struktur und Geometrie eingestellt werden, wobei die erzielbaren Toleranzen im Bereich von Mikrometern bis zu Nanometern liegen. Beim Heißprägen sind nur wenige Parameter, wie Temperatur, Anpressdruck und Verweilzeit (Prägezeit, Geschwindigkeit), zu kontrollieren, um eine gleichbleibende Qualität der übertragenen Schichten zu erhalten. Demgegenüber ist der Flachbettsiebdruck technologisch viel aufwendiger und schlechter kontrollierbar, da, wie bereits erwähnt, Kanten ausbrechen oder Lösungsmittel aus dem Druckmedium während des Druckvorgangs entweichen können.

Bei dem Bindemittel kann es sich sowohl um ein Bindemittel aus einem Stoff oder um ein Stoffgemisch handeln, beispielsweise ein Bindemittelgemisch. Das Stoffgemisch kann aus organischen Bestandteilen bestehen, aber es kann auch ein Gemisch aus organischen und anorganischen Bestandteilen sein. Bei den in der Bindemittelmatrix eingebundenen Partikeln handelt es sich vorzugsweise um anorganische Partikel mit einem mittleren Durchmesser von 10 bis 300 nm.

Weitere vorteilhafte Ausbildungen sind in den Unteransprüchen bezeichnet.

Es kann vorgesehen sein, dass das Substrat ein anorganisches Material ist, insbesondere ein Silizium-Wafer, wie er zum Beispiel zur Herstellung von Solarzellen verwendet wird.

Es kann vorgesehen sein, dass nach dem Übertragen der mindestens einen Transferschicht oder zwischen zwei aufeinander folgenden Prägevorgängen ein Sinterungsprozess ausgeführt wird. Mit dem Sinterungsprozess kann beispielsweise die Haftung der übertragenen Transferschicht auf dem Trägersubstrat, beispielsweise auf dem Silizium-Wafer, verbessert werden und/oder es können organische Bindemittel oder Bindemittel mit einem Siedepunkt oder Sublimationspunkt kleiner oder gleich der Sintertemperatur aus der übertragenen Transferschicht ausgetrieben werden. Mit den Prozessparametern Sintertemperatur und Sinterdauer kann beispielsweise die gegenseitige Diffusion der aneinandergrenzenden Materialien beeinflusst werden, so dass durch wechselseitige Diffusion eine Grenzschicht ausgebildet wird, in der Transferschicht und Trägersubstrat stoffschlüssig miteinander verbunden sind. Es ist aber auch möglich, dass nur eine Abschlusssinterung nach dem Abprägen der letzten Transferschicht vorgesehen ist. Vorzugsweise wird die Sintertemperatur hierbei so gewählt, dass durch den Sinterschritt die Bindemittel ausgetrieben werden und die Partikel miteinander und mit dem Trägersubstrat stoffschlüssig verbunden werden.

Weiter kann vorgesehen sein, dass zwei oder mehrere Sinterungsprozesse bei unterschiedlicher Temperatur und/oder Verweilzeit ausgeführt werden.

Es kann vorgesehen sein, dass die Sinterungstemperatur im Bereich von 300 °C bis 800 °C eingestellt wird.

Vorzugsweise kann vorgesehen sein, dass die Sinterungstemperatur im Bereich von 450 °C bis 550 °C eingestellt wird.

Wie Versuche gezeigt haben, kann es zur Ausbildung von Elektroden auf Silizium-Wafern vorteilhafterweise vorgesehen sein, dass die Sintertemperatur auf ca. 500 °C eingestellt wird. Die Sinterzeit kann zwischen ca. 10 Minuten und ca. 30 Minuten betragen, wobei die Sintertemperatur für etwa 5 Minuten gehalten wird. Nach einem Sinterungsprozess bzw. nach einem Temperaturbehandlungsprozess, wie beispielsweise Tempern, kann ein Kühlschritt vorgesehen sein.

Es können auch Temperaturbereiche von maximal bis 190 °C für die Wärmebehandlung gewählt werden, wenn es sich bei dem Substrat um einen Thermoplast oder dergleichen temperaturempfindliches Material handelt. Die vorgenannten hohen Sintertemperaturen sind insbesondere für anorganische Werkstoffe, beispielsweise für Silizium-Wafer oder für Keramik vorgesehen.

Es ist möglich, dass nach dem Übertragen der mindestens einen Transferschicht oder zwischen zwei aufeinander folgenden Prägevorgängen das Bindemittel chemisch ausgetrieben wird, beispielsweise mittels eines Ätzmittels oder eines Lösungsmittels oder dass das Bindemittel ausgewaschen wird. Beispielsweise können als Bindemittel Acrylatverbindungen vorgesehen sein, die mittels Methylethylketon (MEK) in Lösung überführt werden kann. Wichtig ist hierbei, dass die (leitende) Matrix nicht zerstört oder abgetragen wird und der Partikelverbund erhalten bleibt. Anschliessend kann der oben beschriebene Sinterprozess erfolgen.

Weiter kann vorgesehen sein; dass der Sinterungsprozess bzw. der Temperaturbehandlungsprozess in einer von Luft verschiedenen Atmosphäre durchgeführt wird, beispielsweise in einer Schutzgasatmosphäre, wie Stickstoff oder Argon, um Reaktionen mit dem Luftsauerstoff zu vermeiden. Andererseits kann die bei dem Temperaturbehandlungsprozess verwendete Atmosphäre vorgesehen sein, um gezielt chemische Reaktionen auszulösen, beispielsweise um die Ausbildung einer Oxidschicht zu fördern oder um organische Bestandteile in die Gasphase zu überführen.

Es können auch zwischen dem einen oder den mehreren Sinterungsprozess(en) und/oder Temperaturbehandlungsprozess(en) eine oder mehrere Reinigungsphase(n) vorgesehen sein. Die Reinigungsphasen können beispielsweise vorgesehen sein, um das Bindemittel oder Reste davon zu entfernen, wie weiter oben beschrieben. Die Reinigungsphasen können weiter dazu vorgesehen sein, die Substratoberfläche sowie die Oberfläche der auf das Substrat übertragenen Transferschicht mit Gasen und/oder Flüssigkeiten zu beaufschlagen und dabei zu konditionieren.

Die Temperaturregime und/oder die Verweilzeitregime in den Reinigungsphasen oder in der Reinigungsphase können variiert werden, um einen optimalen Reinigungseffekt und/oder Konditionierungseffekt zu erzielen.

Es kann weiter vorgesehen sein, dass auch nach einem oder mehreren Prägevorgängen Reinigungsphasen durchlaufen werden.

Es ist auch möglich, dass nach einem oder mehreren Prägevorgängen chemische Prozessschritte eingefügt werden, bei denen beispielsweise Schichten partiell oder vollständig angelöst werden, wobei zahlreiche Prozessparameter einstellbar sind, wie beispielsweise die chemische Zusammensetzung der mit dem Substrat in Kontakt gebrachten Stoffe, die Verweilzeit der hinzugefügten chemischen Stoffe, die Prozesstemperatur und der Prozessdruck.

Weiter kann vorgesehen sein, dass in die offenen Poren der auf das Substrat übertragenen Transferschicht ein Füllstoff eingebracht wird. Dieser Füllstoff kann vorgesehen sein, um die chemischen und/oder physikalischen Eigenschaften der übertragenen Transferschicht für den gewünschten Einsatzzweck zu modifizieren. Bei dem Füllstoff kann es sich um einen Stoff oder um ein Stoffgemisch handeln.

Es ist möglich, dass der Füllstoff ein elektrisch leitfähiges oder ein halbleitendes Material ist. Es kann also vorgesehen sein, dass die erfindungsgemäße Struktur aus elektrisch nicht leitfähigen Partikeln ausgebildet ist und in die Poren der elektrisch nicht leitfähigen Struktur ein elektrisch leitfähiger Füllstoff eingebracht wird.

Es ist auch möglich, dass der Füllstoff ein katalytisch wirkendes Material ist.

Es ist auch möglich, dass der Füllstoff eine Schicht auf der Oberfläche der Poren bildet, welche die Poren nicht vollständig ausfüllt. Eine solche Schicht kann beispielsweise eine Dicke von einigen Nanometern aufweisen und eine Fläche bedecken, die um ein Vielfaches größer als die Oberfläche der auf das Substrat übertragenen Transferschicht sein kann. Die Porenoberfläche kann beispielsweise - wie oben aufgeführt - mit einem Katalysator beschichtet sein. Die Poren haben vorzugsweise einen mittleren Durchmesser von 500 bis 5000 nm. Die Schichtdicke der auf die Porenoberfläche aufgetragenen Füllstoffschicht kann 2 % bis 20 % des mittleren Porendurchmessers betragen.

Weiter kann vorgesehen sein, dass eine poröse Leiterbahn oder Elektrode ausgebildet wird, indem die Transferschicht in einem Bereich, in dem die Transferschicht von der Prägefolie vollständig oder bereichsweise auf die Oberfläche des Substrats übertragen wird, als Partikel elektrisch leitfähige Partikel enthält und dass sodann in der auf das Substrat übertragenen Transferschicht offene Poren erzeugt werden, indem das Bindemittel ausgetrieben wird und hier durch weiter poröse, elektrisch leitfähige Strukturen auf dem Substrat gebildet werden.

Es ist auch möglich, dass eine poröse Leiterbahn oder Elektrode ausgebildet wird, indem die mindestens eine Transferschicht als eine elektrisch nicht leitende Transferschicht ausgebildet wird und von der Prägefolie vollständig oder bereichsweise auf die Oberfläche des Substrats übertragen wird, dass in der auf das Substrat übertragenen Transferschicht offene Poren erzeugt werden, indem das Bindemittel ausgetrieben wird, und dass sodann in die offenen Poren ein elektrisch leitfähiges oder ein elektrisch halbleitendes Material als Füllstoff eingebracht wird.

Ebenso sind katalytisch wirkende Schichten ausbildbar (wie oben dargestellt), indem die Transferschicht aus katalytisch wirkenden Partikeln und einem Bindemittel gebildet wird, und das Bindemittel nach dem Übertragen der Transferschicht ausgetrieben wird. Eine solche poröse Katalysatorschicht weist infolge ihrer großen Oberfläche eine hohe Effektivität auf. Es ist aber auch möglich, daß die Oberfläche der Poren erst über einen Füllstoff - der aus einem katalytisch wirkenden Material besteht - die katalytische Wirkung erreichen.

Es kann vorgesehen sein, dass die geometrische Struktur und/oder eine Leitfähigkeitsstruktur der Struktur durch die Ausbildung der Prägefolie und/oder eines Prägestempels eingestellt werden bzw. wird. Es kann beispielsweise vorgesehen sein, dass eine Prägefolie mit einer vollflächigen elektrisch leitfähigen Transferschicht verwendet wird, und dass die Transferschicht bei der Übertragung auf das Substrat durch einen Strukturstempel strukturiert wird. Dabei bestimmt die Oberflächenstruktur des Strukturstempels die Umrisse der übertragenen Transferschicht, wobei diese Kanten scharf ausgebildet werden können. Die nicht benötigten Bereiche der Transferschicht verbleiben nach dem Prägen auf der Prägefolie und werden verworfen.

Es ist möglich, dass die Transferschicht durch Hubprägung übertragen wird.

Es ist weiter möglich, dass die Transferschicht durch Abrollprägung übertragen wird.

Es ist auch möglich, dass die Strukturen in mehr als einem Prägeschritt erzeugt werden. Es kann also vorgesehen sein, beispielsweise Leiterbahnen abschnittsweise zu prägen.

Es kann weiter vorgesehen sein, dass nacheinander Transferschichten aus unterschiedlichem Material und/oder mit unterschiedlicher elektrischer Leitfähigkeit und/oder mit unterschiedlicher geometrischer Struktur und/oder mit unterschiedlichem Querschnittsprofil übertragen werden. Auf diese Weise können die Eigenschaften der Strukturen in vielfältiger Weise variiert werden. Insbesondere ist es möglich, sie bereichsweise zu variieren, beispielsweise Bereiche als Elektroden und Bereiche als Leiterbahnen oder dergleichen auszubilden. Die Leiterbahnen können beispielsweise Elektroden photovoltaischer Zellen miteinander verbinden. Auf diese Weise sind durch Serien- und/oder Parallelschaltungen photovoltaischer Zellen photovoltaische Module ausbildbar.

Es ist weiter möglich, dass durch Übertragen von zwei oder mehr Transferschichten in der Struktur ein Leitfähigkeitsgradient erzeugt wird, beispielsweise wenn die einzelnen Transferschichten unterschiedliche Leitfähigkeiten und Innenwiderstände aufweisen.

Es kann vorgesehen sein, dass die geometrische Struktur und/oder eine Leitfähigkeitsstruktur der Struktur durch die Ausbildung des Prägestempels und/oder der Prägefolie eingestellt wird bzw. werden, wie weiter oben beschrieben. Es kann also beispielsweise vorgesehen sein, Leiterbahnbereiche von einer Prägefolie mit strukturierter Transferschicht zu übertragen und/oder Leiterbahnbereiche mittels eines Strukturstempels von einer Prägefolie mit vollflächiger Transferschicht zu übertragen.

Es ist möglich, beide Methoden miteinander zu kombinieren. Es kann beispielsweise eine Prägefolie vorgesehen sein, deren Transferschicht sowohl strukturierte als auch unstrukturierte Bereiche aufweist und weiter ein Prägestempel, der bereichsweise als Strukturstempel ausgebildet ist.

Weiter kann vorgesehen sein, dass durch Übertragen von zwei oder mehr Transferschichten die Haftung der Struktur lokal variiert wird. Die unterschiedliche Haftung kann durch unterschiedliche Strukturierung der Transferschicht und/oder unterschiedliche Zusammensetzung der Transferschicht und/oder durch eine oder mehrere Schichten der Prägefolie hervorgerufen sein. Es können beispielsweise Schichten vorgesehen sein, die als Kleberschicht oder als Trennschicht wirken oder die im Ergebnis eines Sinterungsprozesses eine unterschiedliche Haftwirkung hervorrufen.

Weiter ist es möglich, dass Prägefolien mit Trägerschichten verwendet werden, die sich in mindestens einer Eigenschaft voneinander unterscheiden, beispielsweise Dicke und/oder Flexibilität und/oder stoffliche Zusammensetzung.

Weiter kann vorgesehen sein, dass die übertragene Transferschicht mit mindestens einer Schutzschicht beprägt wird, beispielsweise wenn es sich um eine Leiterbahn oder eine Elektrode handelt. Die Wahl der Schutzschicht und der Art und Weise der Aufbringung der Schutzschicht kann entscheidenden Einfluss auf die Lebensdauer und die qualitätsgerechte Funktion des Produktes haben, das mit dem erfindungsgemäßen Verfahren gefertigt wird. Dabei ist neben den physikalischen und/oder chemischen Eigenschaften der übertragenen Schutzschicht die Auswahl der Kleberschicht, die die Haftung der Schutzschicht vermittelt, von Bedeutung. Wie bereits weiter oben ausgeführt, können diese wichtigen Parameter im wesentlichen bereits bei der Herstellung der Prägefolie eingestellt werden, so dass an den Prägeprozess selbst geringere Anforderungen gestellt werden können und somit die Fertigungskosten auch bei kleinen Stückzahlen niedrig sein können.

Es ist auch möglich, dass als Abschlussschicht eine Transferschicht aufgebracht wird, die ein optisch variables Element aufweist. Bei dem optisch variablen Element kann es sich beispielsweise um ein Firmenlogo oder dergleichen handeln, das zugleich als ein Echtheitszertifikat nutzbar ist, wenn das optisch variable Element als ein Sicherheitselement ausgebildet ist (Hologramm, Beugungsgitter oder dergleichen).

Weitere vorteilhafte Ausbildungen sind auf die Prägefolie gerichtet.

Die Trägerfolie der Prägefolie besteht vorzugsweise aus einer flexiblen Kunststofffolie einer Dicke von weniger als 200 µm, bevorzugt von weniger als 50 µm. Die Trägerfolie kann soaus einer Kunststofffolie mit einer Dicke von vorzugsweise 12 µm bis 150 µm ausgebildet sein, noch weiter vorzugsweise von 12 µm bis 50 µm ausgebildet sein. Als Material der Kunststofffolie kann beispielsweise PET (Polyethylenterephthalat) oder BOPP (biaxial gestrecktes Polypropylen) vorgesehen sein.

Es kann vorgesehen sein, dass es sich bei den Partikeln um elektrisch leitfähige Partikel handelt.

Es kann vorgesehen sein, dass die mindestens eine Transferschicht aus einem Gemisch von Partikeln und dem Bindemittel, insbesondere Bindemittelpartikeln gebildet ist. Wie bereits mehrfach in anderem Zusammenhang verwiesen, ist es mit dem erfindungsgemäßen Verfahren und mit der erfindungsgemäßen Prägefolie möglich, die Ausbildung der Strukturen, zum Beispiel Leiterbahnen bereits bei der Herstellung der Prägefolien "maßzuschneidern" und zugleich in ein Verfahren der Massenfertigung zu verlagern.

Es kann vorgesehen sein, dass es sich bei den elektrisch leitfähigen Partikeln um Metallpartikel handelt. Diese Partikel besitzen vorzugsweise einen mittleren Durchmesser von 10 bis 50 nm und bestehen aus Silber oder Kupfer oder einer Legierung dieser Metalle. Auf der Basis von Metallpartikeln sind nicht nur herkömmliche metallische Leiterbahnen und/oder Elektroden herstellbar, sondern es sind auch hybride Leiterbahnen und/oder Elektroden herstellbar, d. h. mit nichtmetallischen leitenden und/oder halbleitenden Komponenten. Beispielsweise können metallischen Partikel eine Matrix bilden, in welche nichtmetallische Partikel eingebettet sind. Dabei kann durch Variation des Mischungsverhältnisses beispielsweise die Leitfähigkeit der übertragenen Transferschicht eingestellt werden. Es ist aber auch möglich, dass die den metallischen Partikeln beigemischte Komponente nach dem Aufbringen der Transferschicht aus der Transferschicht ausgetrieben wird und so beispielsweise eine poröse Elektrode und/oder eine matrixförmige Elektrode erhalten wird, oder dass in die poröse Transferschicht nach dem Auftragen und Austreiben der vorgenannten Komponente der vorgesehene Füllstoff eingebracht wird oder mehrere Füllkomponenten eingebracht werden, wie weiter oben beschrieben. Bei dem besagten Füllstoff bzw. den Füllstoffkomponenten kann es sich beispielsweise um Stoffe handeln, die während des Sinterprozesses zerstört würden und deshalb erst nachher die Möglichkeit besteht, diese mit einzubinden.

Weiter kann vorgesehen sein, dass es sich bei den elektrisch leitfähigen Partikeln um Kohtenstoff-Nanotubes handelt. Der Begriff "Kohlenstoff-Nanotubes" bezeichnet hier einerseits Kohlenstoff-Nanotubes an sich, als auch weitere andere Materialien, deren Eigenschaften im Wesentlichen durch ihre Nanostruktur bestimmt sind. Diese vorzugsweise aus Kohlenstoff gebildeten und diese Eigenschaft zeigenden Partikel besitzen dabei Abmessungen, die kleiner sind als die Wellenlängen des sichtbaren Lichtes.

Weiter kann vorgesehen sein, dass es sich bei den elektrisch leitfähigen Partikeln um Partikel aus mindestens einem elektrisch leitfähigen Polymer handelt.

Es ist auch möglich, dass es sich bei den Partikeln um halbleitende Partikel handelt. Die Partikel können hierbei aus einem anorganisch- oder organischen halbleitenden Material, beispielsweise einer Si-Legierung, bestehen. Diese Partikel besitzen vorzugsweise einen mittleren Durchmesser von ca. 50-100 nm.

In einer vorteilhaften Ausbildung kann vorgesehen sein, dass es sich bei den halbleitenden Partikeln um elektrisch halbleitende TiO₂-Partikel, insbesondere um TiO₂-Nanopartikel handelt. Diese über eine oder mehrere Transferschichten incl. weiteren Prozessstufen gebildete Schicht kann dabei Anwendung in der Herstellung ein photovoltaischen Grätzelzelle (Flüssigkeitszelle) finden.

Es kann sich bei den halbleitenden Partikeln auch um Partikel aus mindestens einem halbleitenden Polymer handelt. Strukturen aus leitenden und/oder halbleitenden Polymeren können beispielsweise zur Ausbildung von photovoltaischen Zellen auf Polymerbasis (OPV) oder von photovoltaischen Farbstoffzellen (DSSC) vorgesehen sein.

Weiter kann vorgesehen sein, dass es sich bei den Partikeln um elektrisch nichtleitende Partikel handelt. Diese Partikel bestehen vorzugsweise aus einem anorganischen, nicht elektrisch leitfähigen Material, beispielsweise Glaskügelchen. Es ist jedoch auch möglich, dass diese Partikel aus einem organischen, elektrisch nichtleitenden Material, beispielsweise mitunter aus PET (polyethylent terephthalate) bestehen. Bei Austreibung des Bindemittels mittels eines Sinterprozesses oder einer Wärmebehandlung werden als Material für die Partikel vorzugsweise Materialien eingesetzt, die sich bei der Sintertemperatur bzw. Prozesstemperatur der Wärmebehandlung zu höchstens 10 %, vorzugsweise zu höchstens 5 %, am meisten bevorzugt gar nicht zersetzen oder verflüchtigen. Als Material für die Partikel können hierbei anorganische Stoffe, die Gerüststrukturen ausbilden, wie beispielsweise SiO₂ Silane, eingesetzt werden. Ferner ist es möglich, dass geeignete Partikel Siloxane und/oder organische Polymere enthalten. Als Material für die Partikel sind insbesondere Duroplaste wie beispielsweise Polyester, Formaldehydharze, Epoxidharze, Polyurethan und/oder Copolymere und/oder Mischungen davon geeignet. Vorzugsweise weisen die Duoplaste Fluorgruppen, Aromatengruppen und/oder Heterozyklengruppen auf. Als Duroplaste können ferner beispielsweise Polyphenylensulfid, Polyphenylensulfone, Polyethenketone eingesetzt werden. Dabei werden die Partikel vorzugsweise in einer Form eingesetzt, dass diese entweder vor und/oder nach dem Sinterprozess Gerüststrukturen aus den vorstehend definierten Materalien ausbilden.

Die Partikel können beispielsweise eine Stützmatrix zur Aufnahme von Füllstoffen bilden. Die Partikel besitzen vorzugsweise einen mittleren Durchmesser von 100 bis 300 nm, wobei aber auch andere Größen oder auch Größengemische vorstellbar sind.

Es ist auch möglich, dass es sich bei den Partikeln um katalytisch wirkende Partikel handelt, beispielsweise bestehend aus Platin wie weiter oben ausgeführt. Die Partikel besitzen vorzugsweise einen mittleren Durchmesser von 20 bis 50 nm.

Es ist möglich, dass die Partikel annähernd gleiche Abmessungen aufweisen. Unter "annähernd gleichen" Abmessungen wird verstanden, dass die Abmessungen um einen Mittelwert schwanken können, beispielsweise in einer Gaußschen Verteilung vorliegen.

Es ist aber auch möglich, dass die Partikel unterschiedliche Abmessungen aufweisen. Unter "unterschiedlichen Abmessungen" ist verstanden, dass die Abmessungen sich soweit voneinander unterscheiden, dass sie mindestens in zwei Größengruppen klassifizierbar sind, beispielsweise in Partikel mit Abmessungen im Nanometerbereich und in Partikel mit Abmessungen im Mikrometerbereich. Dabei können die Partikel einer Größengruppe wiederum in einer Gaußschen Verteilung oder in einer anderen Verteilung - z.B. in einer bimodalen Verteilung vorliegen.

Es kann weiter vorgesehen sein, dass die Volumen-Konzentration der Partikel in der mindestens einen Transferschicht nicht konstant ist. Die Volumen-Konzentration kann beispielsweise durch Variation des Bindemittelanteils bei der Herstellung der Transferschicht eingestellt werden oder durch partielles Entmischen der noch flüssigen Transferschicht durch Schwerkraftwirkung, wie sie beispielsweise bei Farbaufträgen an senkrechten Wänden zu beobachten ist.

Es kann vorgesehen sein, dass das Bindemittel durch einen Temperaturprozess austreibbar ist. Unter austreibbar ist vorzugsweise zu verstehen, dass das Bindemittel einen Siedepunkt und/oder Sublimationspunkt und/oder eine Zersetzungstemperatur kleiner oder gleich der Sintertemperatur aufweist. Bezüglich der Sintertemperatur wird auf die vorhergehenden Ausführungen verwiesen. Als durch einen Wärmeprozess austreibbare Bindemittel kommen beispielsweise sublimierende Stoffe in Frage. Als Bindemittel werden hierbei vorzugsweise Materialien, insbesondere organische Polymere eingesetzt, die bei der Sintertemperatur bzw. der Prozesstemperatur der Wärmebehandlung sich zu mindestens 90 %, vorzugsweise zu 95 %, verflüchtigen und/oder zersetzen. Als Bindemittel für die oben beschriebenen anorganischen, leitfähigen, nicht leitfähigen und halbleitenden Partikel sowie für die oben beschriebenen organischen, elektrisch leitfähigen, nicht leitfähigen und halbleitenden Partikel können hierbei beispielsweise organische Polymere verwendet werden. Als organische Polymere sind insbesondere Thermoplaste, wie beispielsweise Polyethylen, Polypropylen, Polystyrol, Polyvinylchlorid, Polyacrylnitrat, Polyamide, Polyester, Polyacrylate, Acrylat-Verbindungen und/oder Poly(meth)acrylate geeignet. Ferner sind als organische Polymere beispielsweise Zelluloseverbindungen geeignet.

Weiter können dem Bindemittel noch Lösungsmittel zugesetzt werden. Die Volumen-Konzentration der Partikel bezogen auf das Bindemittel beträgt vorzugsweise 40 bis 80 Vol.-%. Durch die Volumenkonzentration des Bindemittels wird die Porosität der Struktur eingestellt. Je höher die Volumenkonzentration der Partikel gewählt wird, umso geringer ist der Volumenanteil der Poren in der Struktur.

Es ist möglich, dass der Temperaturprozess zugleich einen chemischen Prozess auslöst, der ein zunächst chemisch nicht lösbares Bindemittel in ein chemisch lösbares Bindemittel überführt. Es können beispielsweise oxidierbare oder thermisch crackbare Bindemittel vorgesehen sein.

Es kann auch vorgesehen sein, dass das Bindemittel durch einen im wesentlichen bei Zimmertemperatur ablaufenden chemischen Prozess austreibbar ist. Es kann sich dabei beispielsweise um ein in einem Lösungsmitttel chemisch lösbares Bindemittel handeln, wie Acrylate oder Acrylatgemisch.

Es kann vorgesehen sein, dass die Prägefolie eine oder mehrere Ablöseschichten aufweist. Als Ablöseschicht kann beispielsweise ein Lack der Zusammensetzung 20 %-Vol. Polyacrylat, 70 %-Vol. Methylethylketon und 10 %-Vol. Butylacetat vorgesehen sein, der im aufgetrockneten Zustand eine Schicht von etwa 1 µm Dicke bildet.

Weiter kann vorgesehen sein, dass die Prägefolie eine oder mehrere Grundierungsschichten aufweist, die auch nur partiell vorgesehen sein können. Die Grundierungsschicht verbessert die Haftung der übertragenen Transferschicht. Es kann sich beispielsweise um eine Kleberschicht handeln, vorzugsweise eine Schicht aus einem Heißkleber, UV-härtbaren Kleber oder Kaltkleber, oder um eine Schicht, die speziell auf das Substrat bzw. zuvor übertragene Transferschichten abgestimmt ist und bevorzugt auf diesen haftet. Als Grundierungsschicht kann beispielsweise ein Lack vorgesehen sein, beispielsweise mit der Zusammensetzung 26 %-Vol. Bindemittel, z.B. Polyester oder Kleber, 4 %-Vol. SiO₂, 50 %-Vol. Methylethylketon und 20 %-Vol.

Hochsieder , wie z. B. Cyclohexanon. Das Auftragsgewicht der Grundierungsschicht kann beispielsweise 0,5 bis 0,8 g/m² betragen, das ergibt eine Schichtdicke von etwa 500 bis 800 nm.

Die Erfindung wird nun anhand der Figuren näher erläutert. Es zeigen:
- Fig. 1 a, b, c: Schematische Schnittdarstellungen von Fertigungsschritten eines ersten Ausführungsbeispiels;
- Fig. 2a, b, c: schematische Schnittdarstellungen von Fertigungsschritten eines zweiten Ausführungsbeispiels;
- Fig. 3a, b, c: schematische Schnittdarstellungen von Fertigungsschritten eines dritten Ausführungsbeispiels;
- Fig. 4: eine schematische Schnittdarstellung eines vierten Ausführungsbeispiels;
- Fig. 5: eine schematische Schnittdarstellung eines fünften Ausführungsbeispiels;
- Fig. 6: eine schematische Schnittdarstellung eines sechsten Ausführungsbeispiels;
- Fig. 7a: schematische Schnittdarstellungen von Fertigungsschritten eines
- bis 7e: siebten Ausführungsbeispiels;
- Fig. 8: eine schematische Schnittdarstellung eines achten Ausführungsbeispiels;
- Fig. 9: eine schematische Schnittdarstellung eines neunten Ausführungsbeispiels;
- Fig. 10: eine schematische Schnittdarstellung eines zehnten Ausführungsbeispiels.

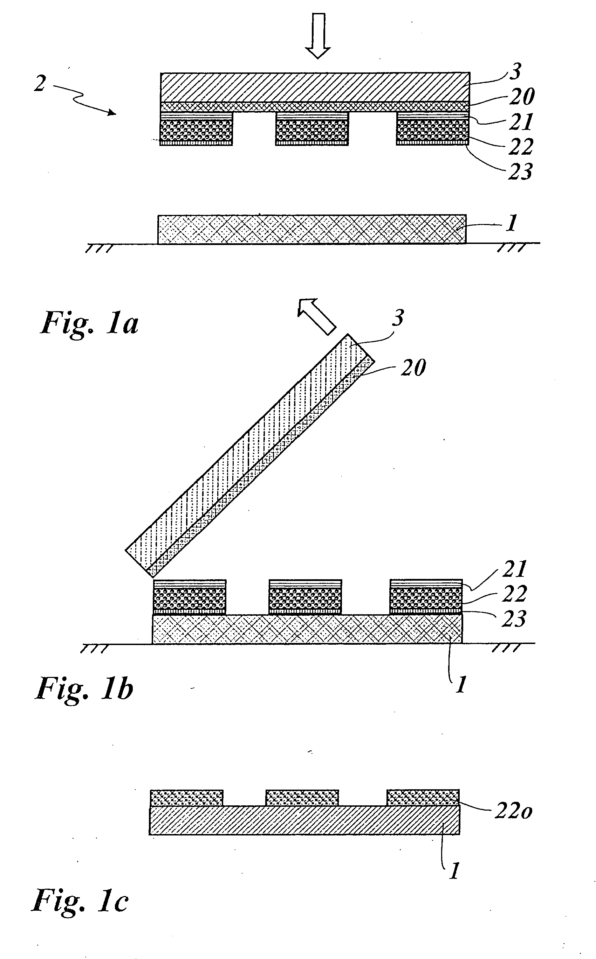

Die Fig. 1 zeigt ein Trägersubstrat 1, das für das Aufbringen einer Elektrodenschicht mittels Heißprägen vorgesehen ist. Als Trägersubstrat 1 können beispielsweise vorgesehen sein:
- Metallfolien mit einer Dicke von 50 bis 150 µm, ggf. mit einer nichtleitenden Deckschicht versehen;
- Glasträger mit einer Dicke von etwa 1 mm;
- dotierte Silizium-Wafer, beispielsweise zum Aufbau einer photovoltaischen Zelle oder eines photovoltaischen Moduls, oder
- Kunststofffolien.

Eine Heißprägefolie 2 ist aus einer Trägerfolie 20, einer Ablöseschicht 21, einer elektrisch leitfähigen Transferschicht 22 und einer Grundierungsschicht 23 gebildet, wobei die Heißprägefolie 2 auf einem beheizten Prägestempel 3 aufgenommen ist. Die Oberflächentemperatur des Prägestempels 3 kann beispielsweise 180 °C bis 190 °C betragen.

Bei der Trägerfolie 20 kann es sich beispielsweise um eine Kunststofffolie von 12 bis 150 µm handeln, vorzugsweise von 12 bis 50 µm handeln. Die Kunststofffolie kann beispielsweise aus PET oder BOPP bestehen. In dem in Fig. 1 dargestellten Ausführungsbeispiel handelt es sich um eine PET-Folie von 19 bis 23 µm Dicke.

Die Ablöseschicht 21 kann beispielsweise aus einem Lack der Zusammensetzung 20 %-Vol. Polyacrylat, 70 %-Vol. Methylethylketon und 10 %-Vol. Butylacetat gebildet sein und im aufgetrockneten Zustand eine Schicht von etwa 1 µm Dicke bilden.

Die elektrisch leitfähige Transferschicht 22 besteht aus einem Bindemittelanteil und der leitfähigen Komponente. Es kann sich bei der Transferschicht 22 um eine aus einem Lack, der die Zusammensetzung 56 %-Vol. einer pulverförmigen metallischen Komponente, wie Gold, Silber, Aluminium, Kupfer oder einer Legierung aus diesen Metallen, 19 %-Vol. Bindemittel und 25 %-Vol. Lösungsmittel hatte, gebildete Lackschicht handeln, die im aufgetrockneten Zustand eine Transferschicht von ca. 25 µm Dicke bildet. Als Bindemittel können beispielsweise Acrylatverbindungen und als Lösungsmittel beispielsweise Gemische aus Ketonen und Aromaten verwendet werden. Es kann sich aber auch um eine Lackschicht handeln, bei der anstelle der metallischen Komponente TiO₂ vorgesehen ist, wobei die Zusammensetzung 25 %-Vol. TiO₂, 10 %-Vol. Bindemittel und 65 %-Vol. Lösungsmittel gewählt sein kann. Die besagten Bindemittel bilden den ersten Füllstoff, der zwischen den elektrisch leitfähigen Bereichen der Transferschicht 22 angeordnet ist. Die Transferschicht 22 kann in bekannter Weise durch Aufdrucken auf die Heißprägefolie aufgebracht sein.

Die Grundierungsschicht 23 ist ebenfalls aus einem Lack gebildet, beispielsweise mit der Zusammensetzung 26 %-Vol. Bindemittel, z.B. Polyester oder Kleber, 4%-Vol. SiO₂, 50 %-Vol. Methylethylketon und 20 %-Vol. Hochsieder, wie z. B. Cyclohexanon (Siedepunkt 155° C). Das Auftragsgewicht der Grundierungsschicht kann beispielsweise 0,5 bis 0,8 g/m² betragen. Die SiO₂-Partikel in der Grundierungsschicht dienen als Abstandshalter beim Aufspulen der Folie und vermeiden "Blocken" oder einen unerwünschten Lacktransfer auf die Rückseite der Trägerfolie 20. Bei der Grundierungsschicht kann es sich auch um eine Kleberschicht handeln, vorzugsweise um eine Schicht aus einem Heißkleber, einem UV-härtbaren Kleber oder einem Kaltkleber.

Die Herstellung der Heißprägefolie kann vorteilhafterweise in einem Rolle-zu-Rolle-Verfahren erfolgen, wobei die vorgenannten Schichten sämtlich durch Druckprozesse übertragbar sind.

Die Rückseite der Trägerfolie 20 ist der Vorderseite des Prägestempels 3 zugewandt. Die Vorderseite der Heißprägefolie 2, die zugleich die Vorderseite Grundierungsschicht 23 ist, ist der Oberseite des Trägersubstrats 1 zugewandt und wird während des Prägeprozesses mit dieser in Kontakt gebracht. Dabei wirkt die Grundierungsschicht 23 als eine Haftvermittlerschicht bzw. als eine Kleberschicht. Durch den Prägeprozess wird die Transferschicht 22 auf die Oberseite des Trägersubstrats 1 übertragen, wie in Fig. 1b dargestellt, und bildet dort Leiterbahnen aus, die als Elektrodenbereiche und/oder Kontaktbereiche und/oder sonstige elektrisch leitfähige Bereiche nutzbar sind.

Nach der Übertragung der Transferschicht 22 wird der Prägestempel 3 abgehoben, wobei die Ablöseschicht 21 die Trennung der Transferschicht 22 von der Heißprägefolie 2 unterstützt.

Fig. 1c zeigt nun das Trägersubstrat 1 mit einer nachbehandelten Transferschicht 22o, bei der das Bindemittel entfernt ist. Das Bindemittel kann aus der auf das Substrat 1 übertragenen Transferschicht 22 in einem Sinterungsprozess entfernt werden. Es kann beispielsweise vorgesehen sein, etwa 10 bis 30 Minuten zu sintern und dabei für etwa 10 Minuten eine Temperatur von etwa 500 °C zu halten. Hierbei werden organische Bestandteile der Ablöseschicht, der Transferschicht und der Kleberschicht ausgetrieben, wobei sie in die Gasphase treten und bei den nicht flüchtigen Bestandteilen der Transferschicht ein Verbund zwischen den Partikeln und dem Substrat erzeugt wird. Die Partikel der nicht ausgetriebenen Komponente sind dabei oberflächlich miteinander verbunden, so dass sich folglich offene Poren ausbilden. Es ist auch möglich, dass das Bindemittel nur teilweise während des Sinterungsprozesses entfernt wird, und der Rest in einem daran sich anschließenden nasschemischen Prozess mit anschließender Reinigung und/oder Trocknung. Möglich ist in diesem Zusammenhang auch, dass ganz auf die Schicht 23 verzichtet werden kann und zwar, wenn das Bindemittel in der Transferschicht ausreicht, um während des Prägevorganges einen Verbund zum Substrat zu gewährleisten. In diesem Zusammenhang ist es auch möglich, daß die Schicht 23 nicht in die Gasphase übertritt und zwar dann, wenn die Verweilzeit oder die Temperaturen während des Sinterprozesses nicht hoch genug gewählt worden sind.

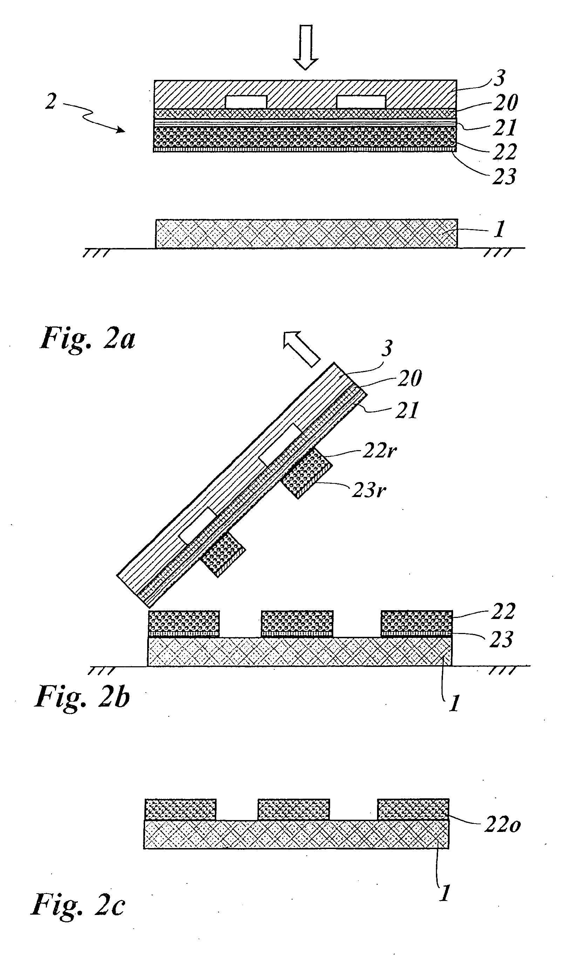

Die Fig. 2a bis c zeigen nun ein zweites Ausführungsbeispiel, bei dem die Transferschicht 22 der Heißprägefolie 2 vollflächig ausgebildet ist (Fig. 2a). Der Prägestempel 3 weist eine Oberflächenstruktur auf, die der zu übertragenden Leitungsstruktur entspricht, wobei die Bereiche zwischen den Leiterbahnen vertieft ausgebildet sind, so dass die Oberfläche des Prägestempels 3 nur in den Bereichen der Leiterbahnen in Kontakt mit der Heißprägefolie 2 steht.

Wie in Fig. 2b dargestellt, werden bei dem Prägen von der Transferschicht 22 nur die Bereiche der Transferschicht 22 auf das Trägersubstrat 1 übertragen, die auf den erhabenen Bereichen des Prägestempels 3 angeordnet sind. Beim Trennen des Prägestempels 3 von dem Trägersubstrat 1 verbleiben diese Bereiche auf dem Trägersubstrat 1. Über den vertieften Bereichen des Prägestempels 3 angeordnete Bereiche 22r der Transferschicht 22 und 23r der Grundierungsschicht 23 verbleiben auf der Heißprägefolie 2 und werden mit dieser beim Abheben des Stempels 3 abgelöst.

Das in den Fig. 2a bis c dargestellte Verfahren kann Vorteile für Versuchsdurchführungen und Kleinserien haben und vorteilhafterweise immer dann vorgesehen sein, wenn die Herstellungskosten des Prägestempels 3 geringer sind als die Herstellungskosten einer mit einer strukturierten Transferschicht ausgebildeten Heißprägefolie. Es kann, wie weiter oben beschrieben, vorgesehen sein, dass die Ablöseschicht zumindest teilweise übertragen wird und beispielsweise in einem nachfolgenden Sinterungsprozess in die Gasphase übertritt. Die partiell übertragene Grundierungsschicht kann dazu bestimmt sein, um die Haftung der auf das Trägersubstrat 1 übertragenen Bereiche der Transferschicht zu verbessern, so dass die unter den ausgesparten Bereichen des Prägestempels 3 angeordneten Bereiche der Transferschicht problemlos abgezogen werden können.

In dem in Fig. 2c dargestellten Ausführungsbeispiel ist das Grundierungsmittel in einem Sinterungsprozess entfernt worden. Es kann beispielsweise vorgesehen sein, etwa 10 bis 30 Minuten zu sintern und dabei für etwa 10 Minuten eine Temperatur von etwa 500 °C zu halten. Hierbei werden organische Bestandteile der Transferschicht, insbesondere das Bindemittel, ausgetrieben und treten in die Gasphase.

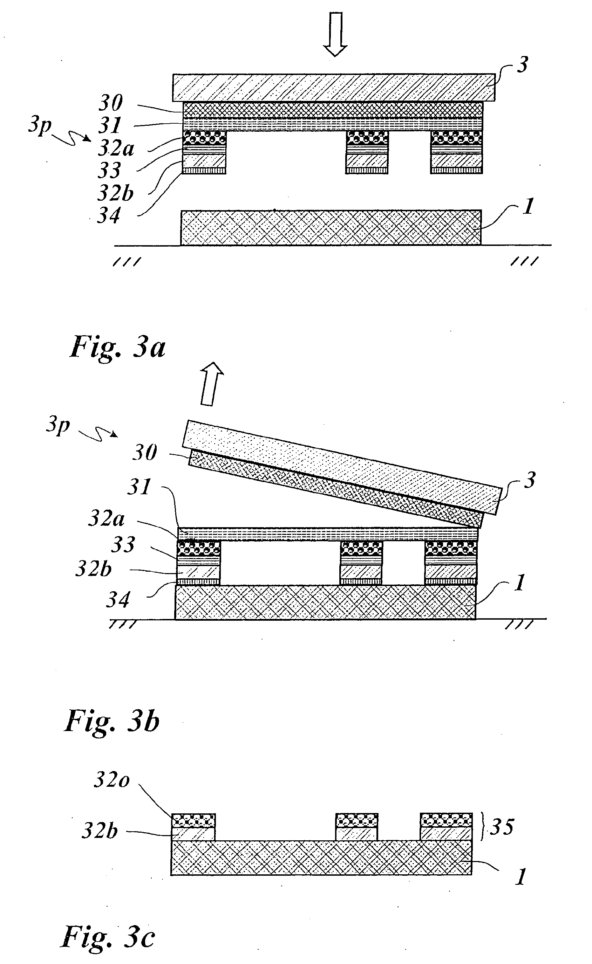

Die Fig. 3a bis c zeigen nun Verfahrensschritte zum Aufbau von mehrschichtigen Elektrodenschichten.

Fig. 3a zeigt eine Heißprägefolie 3p, die mit dem Prägestempel 3 auf das Trägersubstrat 1 gepresst wird. Die Heißprägefolie 3p ist aus einer Trägerfolie 30, einer Ablöseschicht 31, einer ersten elektrisch leitfähigen Transferschicht 32a, einer möglichen Zwischenschicht 33 (z. B. zur Haftverbesserung während des Druckens), einer zweiten elektrisch leitfähigen Transferschicht 32b und einer Grundierungsschicht 34 gebildet.

Beim Heißprägen werden die beiden Transferschichten 32a, 32b gemeinsam übertragen, wie in Fig. 3b dargestellt, wobei nach der Übertragung wiederum ein Sinterprozess vorgesehen ist, der die beiden Transferschichten sowohl untereinander als auch mit der Oberfläche des Trägersubstrats 1 dauerhaft verbindet. Die organischen Bestandteile der Ablöseschicht 31, der Zwischenschicht 33 als auch der Grundierungsschicht 34 werden durch den Sinterungsprozess ausgetrieben.

Die Ablöseschicht 31 ist so eingestellt, dass sie nicht auf der Heißprägefolie 3p, sondern auf der Elektrodenschicht verbleibt. Die Ablöseschicht 31 wird deshalb erst im Sinterungsschritt entfernt.

Die Fig. 3c zeigt nun das Trägersubstrat 1 mit einer strukturierten Elektrodenschicht 35, die aus einer unteren Teilschicht 32b und einer oberen Teilschicht 32o besteht. Bei dem Trägersubstrat 1 kann es sich beispielsweise um einen dotierten Silizium-Wafer handeln, der zum Aufbau einer photovoltaischen Zelle bzw. eines photovoltaischen Moduls vorgesehen ist. Die untere Teilschicht ist 32b ist in dem in Fig. 3c dargestellten Ausführungsbeispiel als eine homogene, nicht poröse teiltransparente Elektrodenschicht ausgebildet. Die obere Elektrodenschicht 32o ist als eine offenporige Elektrodenschicht ausgebildet, deren Poren in einem weiteren Verfahrensschritt mit einem Füllstoff partiell oder vollständig befüllt werden können. In diesem Zusammenhang ist zu erwähnen, dass die Porositäten nicht nur durch den Anteil der flüchtigen Komponente, sondern auch durch das Schmelzverhalten der nicht flüchtigen Komponente und die Wahl der Sintertemperatur eingestellt werden können.

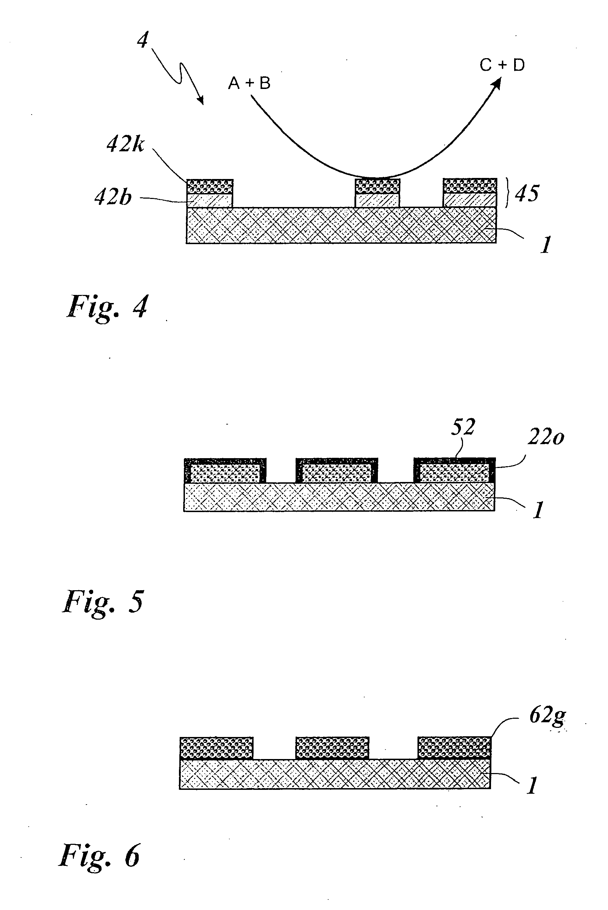

Die Fig. 4 zeigt nun eine ganz andere Verwendungsmöglichkeit von porösen Strukturen auf einem beispielsweise inerten Träger. Auf der Vorderseite des Trägersubstrats 1 ist eine aus zwei Transferschichten 42b und 42k gebildete poröse Matrix 45 aufgebracht, mit einem ähnlichen Aufbau wie in Fig. 3c dargestellt. Die obere poröse Transferschicht 42k wirkt hierbei als Katalysator für eine chemische Reaktion. Die Transferschicht 42k weist eine sehr große Oberfläche auf. Die Transferschicht 42k kann aus einem katalytisch wirkenden Material gebildet sein, es kann aber auch vorgesehen sein, dass die in der Transferschicht 42k ausgebildeten Poren mit einem katalytisch wirkenden Füllstoff oberflächlich - um die vergrößerte Oberfläche nicht zu verlieren - beschichtet sind. Wie in Fig. 4 schematisch dargestellt, wird das chemische Gleichgewicht von den Ausgangskomponenten A und B zu den Endkomponenten C und D verschoben.

Fig. 5 zeigt nun ein weiteres Ausführungsbeispiel, bei dem ausgehend von dem in Fig. 2c dargestellten Zwischenschritt die Elektrodenschicht 22o mit einer galvanisch aufgetragenen metallischen Schicht 52 bedeckt ist.

Fig. 6 zeigt ein sechstes Ausführungsbeispiel, bei dem ausgehend von dem in Fig. 2c dargestellten Zwischenschritt auf dem Trägersubstrat 1 eine Elektrodenschicht 62 ausgebildet ist, die beispielsweise als eine offenporige metallische Schicht aus Kupfer oder Silber ausgebildet ist, die in sich, als auch zum Substrat durch den Sinterungsprozess eine gute Haftung bekommen hat und deren Poren mit dem Füllstoff PEDOT/PSS befüllt sind. Eine solche Elektrodenausbildung kann beispielsweise für den Aufbau von photovoltaischen Zellen bzw. Modulen auf der Basis organischer Halbleiterschichten vorgesehen sein.

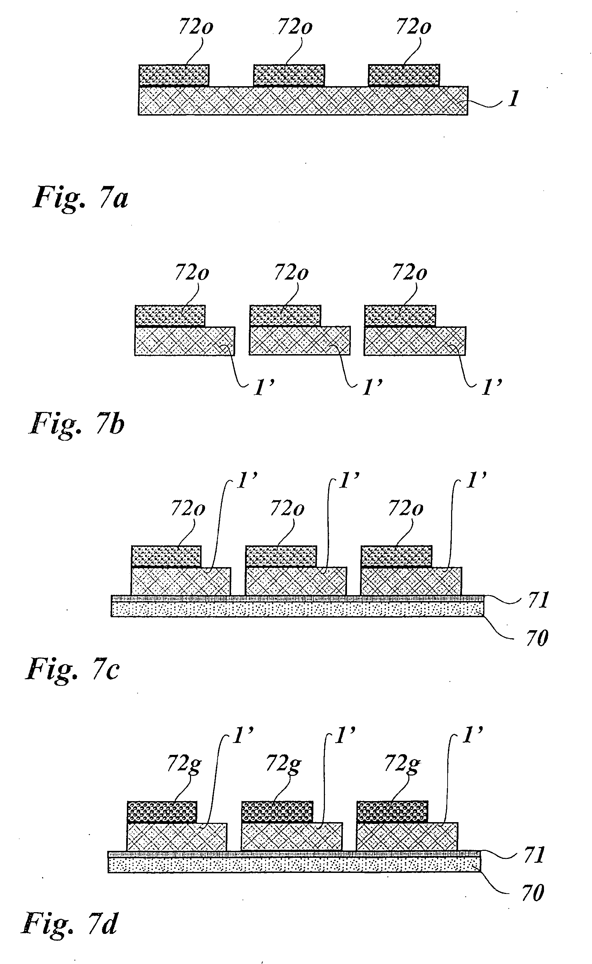

Die Fig. 7a bis 7e zeigen nun Fertigungsstufen zum Aufbau einer photovoltaischen Zelle bzw. Moduls nach dem Prinzip der Farbstoffzelle.

Fig. 7a zeigt als Ausgangskonfiguration analog zu dem in Fig. 2c dargestellten Beispiel auf dem Trägersubstrat 1 eine offenporige Elektrodenschicht 72o, die beispielsweise als metallische Schicht aus Kupfer oder Silber mit einer Dicke von etwa 60 µm ausgebildet ist. Das Trägersubstrat 1 ist in diesem Ausführungsbeispiel ein elektrisch leitfähiges Substrat, beispielsweise ein metallisches Substrat aus mit Gold bedampfter Titanfolie mit einer Gesamtschichtdicke von etwa 20 µm.

Die Transferschicht 72o wird sodann mit Titanat beschichtet bzw. getränkt, indem beispielsweise eine Tetraalkylat-Lösung aufgetragen wird. Das Titanat wird in einem anschließenden Temperaturprozess bei ca. 120 °C und Anwesenheit von hoher Luftfeuchtigkeit in TiOₓ überführt. Nach diesem Schritt sind nun die Poren der offenporigen Elektrodenschicht mit TiOₓ beschichtet. Die Poren weisen beispielsweise in diesem Ausführungsbeispiel einen mittleren Durchmesser von 20 bis 50 nm auf. Das TiOₓ bildet auf der Porenoberfläche eine Schicht mit einer Schichtdicke von etwa 3 nm aus. Es kann aber auch vorgesehen sein, dass die Transferschicht 72o direkt aus einer TiO₂-Matrix gebildet wird, die nach dem Sinterungsprozess das poröse TiO₂-Gebilde formt.

Das Trägersubstrat 1 wird nun in Streifen 1' geschnitten, die jeweils einen Bereich der Transferschicht 72o umfassen, wie in Fig. 7b dargestellt.

Sodann werden die Streifen 1' auf eine elektrisch nicht leitfähige Trägerfolie 70 auflaminiert, beispielsweise auf eine 19 µm dicke PET-Folie, deren Oberseite mit einer Kleberschicht 71 beschichtet ist (Fig. 7c). Als Kleberschicht kann beispielsweise ein Acrylatverbindung mit einer Auftragsdichte von 2g/m² vorgesehen sein.

Sodann wird die beschichtete Elektrodenschicht 72o mit einer Farbstofflösung getränkt und in eine Elektrodenschicht 72g überführt, wie in Fig. 7d dargestellt. Bei der Farbstofflösung kann es sich beispielsweise um eine Lösung aus Ruthenium2,2 AE-Bipyridyl-4,4 AE-dicarboxylat2(NCS)2 handeln.

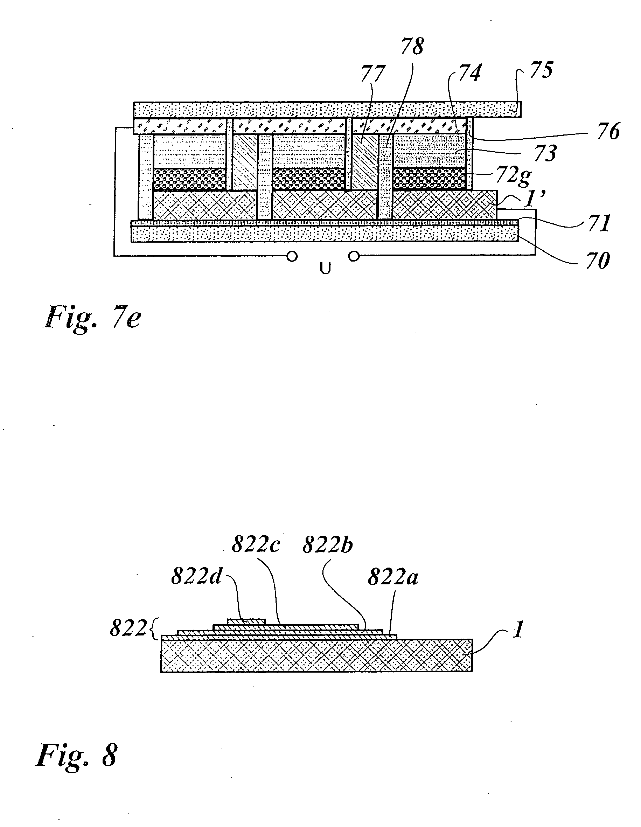

Fig. 7e zeigt nun eine fertig aufgebaute elektrochemische Farbstoffzelle 7, bei der zunächst ausgehend von dem in Fig. 7g gezeigten Aufbau, in die voneinander abgegrenzten Bereiche der Elektrodenschicht 72g jeweils eine Redoxelektrolytschicht 73 eingebracht ist, die beispielsweise eine Lösung aus Jod und Kaliumjodid sein kann. Die Redoxelektrolytschicht 73 kann eine Dicke von etwa 30 µm aufweisen.

Über der Redoxelektrolytschicht 73 ist eine transparente Elektrode 74 angeordnet, die von einer transparenten Deckschicht 75 überdeckt ist. Senkrecht angeordnete Isolatorschichten 76 und 78 trennen die auf der Trägerfolie 70 angeordneten photovoltaischen Zellen voneinander ab, wobei die Isolatorschicht jeweils eine der Stirnseiten der übereinander angeordneten Elektrodenschicht 72g, Redoxelektrolytschicht 73 und transparenten Elektrode 74 überdeckt. Zwischen den beiden Isolatorschichten 76 und 78 sind jeweils zur elektrischen Verbindung benachbarter photovoltaischer Zellen senkrecht verlaufende Verbindungsabschnitte 77 vorgesehen. Der elektrisch leitende Verbindungsabschnitt 77 ist auf der von der photovoltaischen Zelle abgewandten Seite der Isolatorschicht 76 angeordnet und verbindet die Elektrodenschicht 72g der einen benachbarten photovoltaischen Zelle mit der transparenten Elektrode 74 der anderen benachbarten photovoltaischen Zelle. Die Isolatorschicht 78 überdeckt die von der Isolatorschicht 76 abgewandten Stirnseiten des Trägersubstrats 1', der Elektrodenschicht 72g und der transparenten Elektrode 74. Die Isolatorschichten 76 und 78 können jeweils als Kleberschichten zur Abdichtung der photovoltaischen Zellen ausgebildet sein. Von der dauerhaften Abdichtung der photovoltaischen Zellen können u.a. Haltbarkeit und Lebensdauer des vorstehend beschriebenen photovoltaischen Moduls 7 abhängen. Bei Bestrahlung des Moduls, beispielsweise mit Sonnenlicht (z.B. AM1,5 = Standardspektrum), ist zwischen den aus dem leitfähigen Trägersubstrat 1 (Fig. 1) abgetrennten Streifen 1' und der transparenten Elektrode 74 eine elektrische Spannung U abgreifbar.

Fig. 8 zeigt nun ein achtes Ausführungsbeispiel, bei dem auf das Trägersubstrat 1, beispielsweise auf einen Silizium-Wafer, eine aus vier Teiltransferschichten 822a bis 822d gebildete Transferschicht 822 übertragen ist. In dem in Fig. 8 dargestellten Ausführungsbeispiel sind die übertragenen Teiltransferschichten 822a bis 822d unterschiedlich strukturiert, so dass beispielsweise ein Leitfähigkeitsprofil in den Leiterbahnen bzw. Elektrodenbereichen ausgebildet sein kann.

Es kann aber auch vorgesehen sein, dass die Teiltransferschichten 822a bis 822d aus unterschiedlichen Materialien ausgebildet sind. Beispielsweise kann die oberste, außen liegende Teiltransferschicht 822d besonders witterungsbeständig ausgebildet sein, die innerste Teiltransferschicht 822a besonders haftfest ausgebildet sein und die beiden dazwischen angeordneten Teiltransferschichten 822b und 822c können über eine hohe Leitfähigkeit verfügen. In diesem Beispiel könnte die innerste Teiltransferschicht 822a oder der innere Schichtverbund beispielsweise Aluminium enthalten, die außen liegende Teiltransferschicht 822d oder der äußere Schichtverbund Chrom.

Nach jedem Schichtauftrag kann ein Sinterungsprozess vorgesehen sein, wobei weiter vorgesehen sein kann, die Sintertemperatur und die Sinterzeit für jeden Schichtauftrag zu variieren.

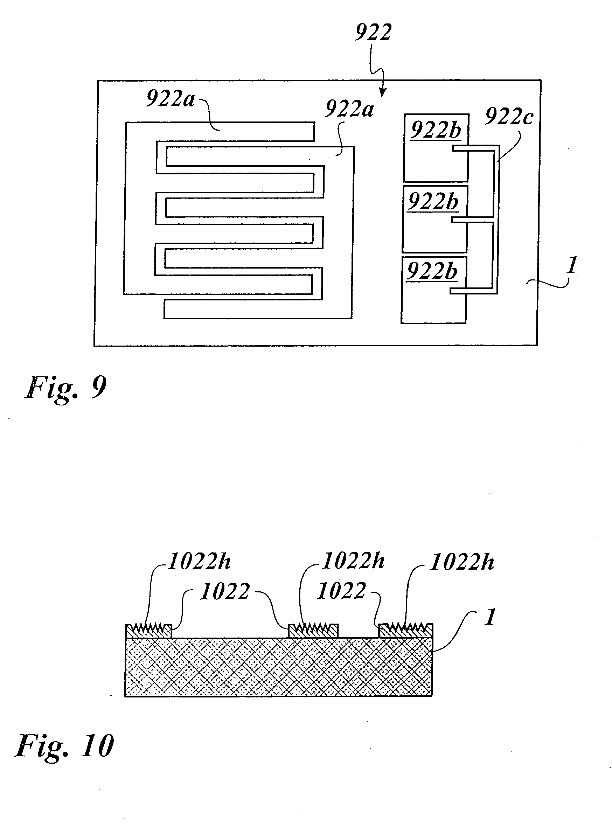

Fig. 9 zeigt nun ein neuntes Ausführungsbeispiel in der Draufsicht, das beispielhaft die Gestaltungsmöglichkeiten des erfindungsgemäßen Verfahrens aufzeigt.

Auf das Trägersubstrat 1 sind nacheinander drei Teiltransferschichten 922a bis 922c übertragen, die Leiterbahnen 922 ergeben. Die Teiltransferschichten 922a und 922b liegen in dem in Fig. 5 dargestellten Ausführungsbeispiel in einer Ebene, ebenso die Bereiche der Teiltransferschicht 922c, die nicht Bereiche der Teiltransferschichten 922b überdecken. Bei den Teiltransferschichten 922b kann es sich beispielsweise Elektrodenschichten handeln. Bei der Teiltransferschicht 922c kann es sich um Leiterbahnen handeln, welche die Teiltransferschichten 922b elektrisch miteinander verbinden. Die Teiltransferschichten 922b und 922c können aus unterschiedlichem Material ausgebildet sein, so dass die Materialeigenschaften den Funktionen "Elektrode" und "Leitungsverbindung" optimal angepasst sein können.

Die Teiltransferschicht 922a kann beispielsweise einen Kondensator oder eine Antennenanordnung bilden, um eine Zusatzfunktion zu realisieren, etwa einen Kondensator oder eine Antenne für einen in den Aufbau integrierten RFID-Chip. Beispielsweise kann das Material und/oder die Querschnittsstruktur und/oder die Oberflächenstruktur-der Teiltransferschicht 922a für diese Funktion optimiert sein. Eine vielfach gegliederte Oberflächenstruktur kann beispielsweise eine wesentlich größere Oberfläche als eine glatte Oberflächenstruktur aufweisen und deshalb für hohe Frequenzen eine bessere elektrische Leitfähigkeit aufweisen, d.h. hinsichtlich der Ausnutzung des sog. Skin-Effekts optimiert sein.

Fig. 10 zeigt nun ein weiteres Ausführungsbeispiel, bei dem auf dem Trägersubstrat 1 Elektrodenschichten 1022 aufgeprägt sind, die personalisiert sind. Die Personalisierung ist nach dem Übertragen der Elektrodenschicht 1022 durch Abprägen eines Oberflächenprofils, beispielsweise eines Hologramms, in Oberfläche der Elektrodenschicht 1022 vorgenommen worden. Die Personalisierung kann beispielsweise vorgesehen sein, um ein fälschungssicheres Echtheitszertifikat aufzubringen.

## Patentansprüche

1. Verfahren zur Erzeugung von Strukturen auf einem Substrat,
**dadurch gekennzeichnet,**
**dass** mindestens eine Transferschicht (22) von einer Prägefolie (2), insbesondere einer Heißprägefolie, vollständig oder bereichsweise auf die Oberfläche des Substrats (1) übertragen wird, wobei die Transferschicht (22) Bereiche aufweist, in denen die Transferschicht (22) Partikel und ein Bindemittel enthält, und dass sodann in der auf das Substrat (1) übertragenen Transferschicht offene Poren erzeugt werden, indem das Bindemittel ausgetrieben wird und hierdurch poröse Strukturen auf dem Substrat erzeugt werden.

2. Verfahren nach Anspruch 1,
**dadurch gekennzeichnet,**
**dass** nach dem Übertragen der mindestens einen Transferschicht (22) oder zwischen zwei aufeinander folgenden Prägevorgängen ein Sinterungsprozess ausgeführt wird.

3. Verfahren nach Anspruch 3,
**dadurch gekennzeichnet,**
**dass** zwei oder mehrere Sinterungsprozesse bei unterschiedlicher Temperatur und/oder Verweilzeit ausgeführt werden.

4. Verfahren nach Anspruch 3 oder 4,
**dadurch gekennzeichnet,**
**dass** die Sinterungstemperatur im Bereich von 300 °C bis 800 °C eingestellt wird, insbesondere von 450 °C bis 550 °C eingestellt wird.

5. Verfahren nach einem der vorangehenden Ansprüche,
**dadurch gekennzeichnet,**
**dass** in die offenen Poren der auf das Substrat übertragenen Transferschicht (22o) mindestens ein Füllstoff eingebracht wird, der insbesondere aus einem elektrisch leitfähigen, einem halbleitenden oder katalytisch wirkendem Material besteht

6. Verfahren nach Anspruch 6,
**dadurch gekennzeichnet,**
**dass** der Füllstoff eine Schicht auf der Oberfläche der Poren bildet, welche die Poren nicht vollständig ausfüllt.

7. Verfahren nach einem der vorangehenden Ansprüche,
**dadurch gekennzeichnet,**
**dass** eine poröse, elektrisch leitfähige Struktur, insbesondere eine Leiterbahn oder Elektrode ausgebildet wird, indem ein Bereich der Transferschicht (22) von der Prägefolie (2) vollständig oder bereichsweise auf die Oberfläche des Substrats (1) übertragen wird, in welchem die Transferschicht (22) neben dem Bindemittel als Partikel elektrisch leitfähige Partikel enthält, und dass sodann in der auf das Substrat (1) übertragenen Transferschicht offene Poren erzeugt werden, indem das Bindemittel ausgetrieben wird und hierdurch poröse, elektrisch leitfähige Strukturen auf dem Substrat erzeugt werden.

8. Verfahren nach einem der Ansprüche 1 bis 6,
**dadurch gekennzeichnet,**
**dass** eine poröse, elektrisch leitfähige Struktur, insbesondere eine Leiterbahn oder Elektrode ausgebildet wird, indem die mindestens eine Transferschicht (22) als eine elektrisch nicht leitende Transferschicht ausgebildet wird und von der Prägefolie (2) vollständig oder bereichsweise auf die Oberfläche des Substrats (1) übertragen wird, dass in der auf das Substrat (1) übertragenen Transferschicht offene Poren erzeugt werden, indem das Bindemittel ausgetrieben wird, und dass sodann in die offenen Poren ein elektrisch leitfähiges oder ein elektrisch halbleitendes Material als Füllstoff eingebracht wird.

9. Verfahren nach einem der vorangehenden Ansprüche,
**dadurch gekennzeichnet,**
**dass** die geometrische Struktur und/oder eine Leitfähigkeitsstruktur der Struktur (22, 822, 922) durch die Ausbildung der Prägefolie (2) und/oder eines Prägestempels (3) eingestellt werden bzw. wird.

10. Verfahren nach einem der vorangehenden Ansprüche,
**dadurch gekennzeichnet,**
**dass** nacheinander Transferschichten aus unterschiedlichem Material und/oder mit unterschiedlicher elektrischer Leitfähigkeit und/oder mit unterschiedlicher geometrischer Struktur und/oder mit unterschiedlicher Querschnittsprofil übertragen werden.

11. Verfahren nach einem der vorangehenden Ansprüche,
**dadurch gekennzeichnet,**
**dass** als Abschlussschicht eine Transferschicht (1022) aufgebracht wird, die ein optisch variables Element (1022h) aufweist.

12. Verfahren nach einem der vorangehenden Ansprüche,
**dadurch gekennzeichnet,**
**dass** das Substrat ein anorganisches Material ist, insbesondere ein Silizium-Wafer.

13. Prägefolie, insbesondere Heißprägefolie, zur Erzeugung von Strukturen auf Substraten,
**dadurch gekennzeichnet,**
**dass** die Prägefolie (2) mindestens eine Transferschicht (22) mit Bereichen aufweist, in denen die Transferschicht (22) Partikel und ein Bindemittel enthält, wobei durch Austreiben des Bindemittels in der Transferschicht (22) offene Poren zur Erzeugung von porösen Strukturen erzeugbar sind.

14. Prägefolie nach Anspruch 13,
**dadurch gekennzeichnet,**
**dass** die mindestens eine Transferschicht (22) aus einem Gemisch von Partikeln, insbesondere elektrisch leitfähige Partikel, halbleitende Partikel, nicht leitende Partikel oder katalytisch wirkende Partikel, und dem Bindemittel, insbesondere Bindemittelpartikeln gebildet ist.

15. Prägefolie nach einem der Ansprüche 13 oder 14,
**dadurch gekennzeichnet,**
**dass** das Bindemittel durch einen Temperaturprozess und/oder einen chemischen Prozess austreibbar ist.

16. Prägefolie nach einem der Ansprüche 13 bis 15,
**dadurch gekennzeichnet,**
**dass** die Prägefolie (2) eine oder mehrere Ablöseschichten (21) aufweist.

17. Prägefolie nach einem der Ansprüche 13 bis 16,
**dadurch gekennzeichnet,**
**dass** die Prägefolie (2) eine oder mehrere Grundierungsschichten (23) aufweist.
